Europäisches Patentamt

European Patent Office

Office européen des brevets

(11) Publication number: **0 159 873**
**A2**

# EUROPEAN PATENT APPLICATION

(21) Application number: 85302570.8

(22) Date of filing: 12.04.85

(51) Int. Cl.⁴: **B 23 K 35/22,** C 09 D 5/08,
H 05 K 3/34

(30) Priority: 12.04.84 US 599540

(43) Date of publication of application: 30.10.85
Bulletin 85/44

(84) Designated Contracting States: **AT BE CH DE FR GB IT
LI LU NL SE**

(71) Applicant: **ELECTRO MATERIALS CORP. OF AMERICA,
605 Center Avenue, Mamaroneck New York 10543 (US)**

(72) Inventor: **Martin, Frank Wayne, P.O. Box 243, Baldwin
Place New York 10505 (US)**
Inventor: **St. John, Frank, 1 Webster Place, Patterson
New York 12563 (US)**

(74) Representative: **Angell, David Whilton, Rohm and Haas
Company Patent Department Chesterfield House
Bloomsbury Way, London WC1A 2TP (GB)**

(54) Coating composition and method for partially soldering a substrate.

(57) The invention concerns a coating composition which may be used to form a peelable solder mask. The coating composition comprises a mixture of vinylic resin, microcrystalline wax and solvent. Applied as a film coating, the coating composition can be used to provide a temporary mask to selected areas of a substrate, for example, a printed circuit, prior to exposure to a solder flux, the mask being readily peelable from the substrate.

COATING COMPOSITION AND METHOD FOR PARTIALLY SOLDERING A
SUBSTRATE

This invention concerns a coating composition which
may be used to form a temporary coating on a portion of the
surface of a substrate, for example, a substrate which is to
be immersed or dipped in solder. When used to form such a
temporary coating, the coating acts as a mask which prevents
solder from adhering to the coated portions of the
substrate.

Prior art solder masks have suffered from
disadvantages or shortcomings that have limited their
usefulness. Prior art solder masks exhibiting inadequate
adhesiveness and strength are susceptible to attack when
exposed to solder flux. Undesirable scratching, chipping,
and partial peeling have resulted in an unsatisfactory or
blotchy product. In some cases, solder masks display
reticulation or cracking believed to result from the attack
of acids which may be present in the solder flux.

A known solder mask is a latex based composition.
Although peelable, it is so gummy in nature that screen
printing is rendered difficult or impractical.

Epoxy based solder masks are also known which require
the mixing of a catalyst or hardener shortly before use.
Therefore, a reasonable shelf life is not possible. In
addition, epoxy-based solder masks are known to experience
undesirable chipping during use.

U.S. Patent-A-4,240,945 to Gabrick teaches a solder
mask composition for use in the manufacture of printed
circuit boards. The composition comprises a mixture of an
alkyd resin and an alkylated amino resin, a minor quantity
of a hydrocarbon resin, an inorganic filler and an organic
solvent. Although this U.S. patent teaches a solder mask
which appears to have some favorable characteristics, it is
not a peelable solder mask.

Other patents, which teach strippable or peelable masks, are not directed to solder mask applications and therefore the masks are not subject to the rigorous conditions inherent in solder dipping. For example, U.S. Patent-A-3,034,915 to Kornbluth teaches strippable coatings for porous articles such as shoes. The coating is intended to protect the articles from damage through soiling or abrasion during the manufacturing process. The coating is peeled off when the fabrication process is complete. Kornbluth teaches employing vinylic resins such as vinyl chloride/acetate copolymers. Mineral oils are utilized to serve as a lubricant. The patent states that mineral oil, by forming a barrier between the deposited web and the protected surface, prevents the web from bonding to the surface. The patent further states that because the mineral oil is incompatible with the other ingredients of the solution, it tends to precipitate out upon the protected surface, thereby causing the plastic film to pull away from the protected surface. Such a maskant would not be capable of withstanding the rigorous conditions inherent in solder dipping.

Defensive Publication T900,017 to Gordy teaches a composition for use as a protective coating on such substrates as automobile parts. The composition comprises a petroleum wax, an ethylene-isobutyl acrylate copolymer, an ethylene-vinyl acetate copolymer and a rosin ester. The petroleum wax is present in an amount of 30 to 60 percent, much higher than the amount disclosed by the present invention.

By practice of the present invention there may be provided one or more of the following:-

(i) a solder mask which is not only screen printable, but which is peelable and therefore readily removable after application to a substrate;

(ii) a composition which forms a film coating capable of withstanding the high temperature and corrosive chemicals present in solder fluxes;

(iii) a heat curable, screen printable solder mask which is removable by peeling off from a substrate, leaving a clean and unaffected surface;

(iv) a solder mask composition wherein the ingredients have excellent compatibility;

(v) a film which has sufficient strength and adhesiveness to prevent blotching or spotting during the soldering process;

(vi) the formulation of a composition comprising releasing agent and binding resin, in a ratio which enables the film coating composed thereof to withstand, without adverse effect, the rigorous thermal and corrosive conditions typical of solder dipping;

(vii) the formulation of a composition which has a shelf life of at least one month and is directly usable as a solder mask without further preparation steps;

(viii) an inexpensive and convenient method of solder masking a printed circuit or other substrate; and

(ix) a method of solder masking a printed circuit in which the masking can be readily removed by peeling off in order to accommodate the circuit board for further component attachment.

According to the present invention there is provided a coating composition comprising:-

(i)     15 to 50% by weight of vinylic resin;

(ii)    30 to 90% by weight of organic solvent; and

(iii) 5 to 15% by weight of microcrystalline wax, the percentages being based on the total weight of vinylic resin, organic solvent and microcrystalline wax.

As used herein in connection with the present invention, the term "vinylic resin" is intended to include any resin containing one or more units of vinyl or vinylidene monomer.

The coating composition of the present invention is capable of withstanding the rigorous process conditions that are associated with solder dipping.  The composition of the invention may be screen printed on a substrate, for example
a printed circuit, and heat cured.  The film coating thus
formed exhibits cohesive strength and chemical resistance
sufficient to withstand exposure to hot solder at a
temperature of 230°C.  The coated substrate remains
protected by the film and displays neither blotching nor
spotting.  The film may readily be removed by peeling off
from the substrate.  The composition of the invention has
the advantage of a long shelf life.

Accordingly, the present invention also provides a
method of partially soldering a substrate, comprising:-

    (a)   applying, to a portion of a substrate
           surface, a coating composition according to the
           invention to form a film of the coating
           composition thereon;

    (b)   curing the film at an elevated temperature for a
           sufficient time to solidify the film;

    (c)   exposing coated and uncoated substrate surface
           to molten solder flux; and

    (d)   subsequently peeling off the film from the
           substrate, whereby the solder does not adhere to
           that portion of the substrate bearing the film.

The portion of the substrate protected by the film
formed from the composition of the present invention is,
after peeling off the film from the substrate, substantially
unchanged and may, for example, have a component attached
thereto without further preparation.

The coating produced using the coating composition of
the present invention will usually be a "thick film" as this
term is understood in the art.

The resin of the composition is vinylic resin.  The
film coating which can be produced with these resins exhibit
excellent flexibility and tear resistance.  A satisfactory
vinylic resin commercially available is Borden Vinyl VC
410M, manufactured by Borden Chemical, a Division of Borden
Inc.  Other vinylic resins may be used which provide the desired strength and flexibility. Examples of suitable resins include polyvinyl chloride, polyvinylidene chloride, polyvinyl acetate, polyvinyl alcohol and polyvinyl acetal homopolymers. Copolymers of vinyl chloride with vinyl acetate or copolymers of vinyl chloride with vinylidene chloride can also be employed. The aforesaid vinylic resins may also be used in combination with one or more other conventional copolymerizable monomeric, oligomeric and prepolymeric compounds. Such admixtures of vinylic resins with other monomers can be employed to control viscosity and/or rate of cure, as well as such variables as hardness and flexibility.

The vinylic resin should be present in the amount of 15% to 50% by weight, based on the total weight of vinylic resin, solvent and wax. Preferably, the vinylic resin is present in an amount of from about 25% to 35% and most preferably about 30% by weight.

The solvent used in the present invention is most preferably gamma butyrolactone. Other suitable solvents include, for example, methyl n-propyl ketone, methyl isopropyl ketone and acetylacetone. The solvent is suitably present in the final composition in an amount of 30% to 90%, particularly 35 to 80%, by weight, based on the total weight of the vinylic resin, solvent and wax.

The wax contributes peelability to the composition. The wax employed in the present invention is microcrystalline material which may be selected from a variety of synthetic or natural types. For example, cetyl, ceryl, or melissyl esters and mixtures thereof are suitable. Carnauba wax, consisting mainly of mericyl cerotate, is an example of a wax which is derived from plant tissue and which can be used in the present invention. Petroleum derived waxes, such as paraffin can also be used in the present invention. A commercially available wax, useful in the composition, is Ross No. 1972, manufactured by Frank B. Ross Co., Inc., Jersey City, New Jersey.

The amount of wax in the composition must be controlled. A certain amount of wax is required to achieve the desired peelability of the film. The wax serves as a releasing agent which permits the film to be readily removed. However, it has been found that too much wax will adversely affect the cohesive strength of the film. Consequently, the film may crumple and not adequately protect the coated substrate.

The wax is present in an amount of 5% to 15%, by weight, based on the total weight of vinylic resin, solvent and wax. A preferred amount is about 10%. The weight ratio of resin to wax is from 4:1 to 2:1, preferably from about 2.5:1 to 3.5:1, and most preferably about 3:1.

Another aspect of the present invention includes the presence of fluorescent pigment, which permits the solder mask to be visible under ultraviolet light. The inclusion of such pigment permits the observation and inspection of the coated areas of the substrate and circuit, both before and after removal of the film. Inspection, following peeling off, assures that the substrate is completely clean of the film, whereas inspection before peeling assures that there are no bald spots or undesired blotches on the substrate. The use of fluorescent pigment is especially suitable in the case of the invention being applied to electronic devices sensitive to ambient light.

A preferred fluorescent pigment is Dayglow Z-14 IMP, manufactured by Day-Glo Color Corp. This pigment may suitably be present in the composition in an amount of about 0.1 to 1.0%, preferably in an amount of about 0.5%, by weight, based on the total weight of vinylic resin, solvent, wax and pigment.

The composition of the present invention may be prepared and used in the following manner. The vinylic resin, solvent, and wax are admixed. For complete homogenization, the mixture is passed through a three roller mill. This mixture or composition is applied to a substrate by screen printing, dipping or brushing. Curing preferably occurs by heating to about 150°C for about 5 minutes. However, the temperature may range from 125 to 165°C for a period of 2 to 180 minutes. The curing may occur on a dryer belt.

The present invention will now be further illustrated by way of the following examples which are presented for purposes of exemplification only and are not intended to limit the scope of the present invention:-

### Example I

To a Hobart Model N-50 mixer were charged 30 g of gamma butyrolactone, 20 g of Borden Vinyl VC 113R resin, 10 g of dibutyl phthalate, 6 g of carnauba wax, and 3 g of a conventional blue dye. After an admixture was formed by stirring, the mixture was transferred to a Ross Model 2.5-5 three roller mill for complete homogenization. The resulting composition was applied to a substrate by screen printing to form a film thereon and subsequently cured for a period of 20 minutes at 165°C.

### Example II

In a Hobart Model N-50 mixer, the following components were mixed: 56.8 g of gamma butyrolactone, 28.4 g of Borden Vinyl VC 401M, 0.5 g of a fluorescent dye known as Dayglow Z-14 IMP, and 9.1 g of Ross 1972 Wax. After an admixture was formed by stirring, the mixture was transferred to a Ross Model 2.5-5 three roller mill for complete homogenization. The resulting composition was applied to a substrate by screen printing to form a film thereon and subsequently cured for a period of 20 minutes at 165°C.

The films prepared according to the above Examples I and II were tested as a solder mask by applying a molten solder flux. The solder flux was a 60/40 Sn/Pb Kester 1544 composition.

The solder resistances exhibited by the films were excellent.  The films were tested to withstand 4 minutes exposure to the solder flux at a temperature of 230°C. Since a typical dipping process only requires a few seconds of such exposure, the endurance exhibited by the present invention is more than adequate.

In both Examples I and II above, the film was observed to maintain a smooth coat which showed no deterioration or adverse effects from the solder flux.  The surface of the substrate was found to have been protected by the film.

In both Examples I and II, the film mask exhibited ease of peelability.  The film mask was readily removed by peeling off, leaving the surface of the substrate essentially clean and unaffected.  In Example II, inspection of the film was aided by the fluorescent dye, which made the film observable under ultraviolet light.

It has been found that a relatively thick coating words best.  The preferred thickness is about 50 micrometres.  When printed too thin, below about 35 micrometres, the film did not peel off as easily.

The coating composition of the present invention has a broad range of workable viscosities.  The composition may be thinned down by solvent according to circumstances.  For example, screen printing requires not too high a viscosity. However, good coverage requires not too low a viscosity.  A suitable range of viscosity has been found to be about 5 to 6.5 Pa s (5000 to 6500 centipoise).

The composition of the invention has a long shelf life.  A shelf life of one month is typical and a shelf life of up to one year may be expected.

CLAIMS

1.      A coating composition comprising:-
   (i)    15 to 50% by weight of vinylic resin;
   (ii)   30 to 90% by weight of organic solvent; and
   (iii)  5 to 15% by weight of microcrystalline wax,
          the percentages being based on the total
          weight of vinylic resin, organic solvent and
          microcrystalline wax.

2.      A coating composition as claimed in claim 1, in which
35 to 80% by weight of organic solvent is present, based on
the total weight of vinylic resin, organic solvent and
microcrystalline wax.

3.      A composition as claimed in claim 1 or claim 2, in
which the weight ratio of vinylic resin to microcrystalline
wax is 4:1 to 2:1.

4.      A composition as claimed in claim 3, in which the
weight ratio of vinylic resin to microcrystalline wax is
3.5:1 to 2.5:1.

5.      A composition as claimed in any of claims 1 to 4, in
which the vinylic resin comprises polyvinyl chloride,
polyvinylidene chloride, polyvinyl acetate, polyvinyl
alcohol, polyvinyl acetal homopolymer, vinyl chloride/vinyl
acetate copolymer and/or vinyl chloride/vinylidene chloride
copolymer.

6.      A composition as claimed in any of claims 1 to 5, in
which the organic solvent comprises gamma butyrolactone,
methyl n-propyl ketone, methyl isopropyl ketone and/or
acetylacetone.

0159873

7.    A composition as claimed in any of claims 1 to 6, in which the wax comprises one or more of paraffin, carnauba wax, or cetyl, ceryl or melissyl esters.

8.    A method of partially soldering a substrate, comprising:-

     (a) applying, to a portion of a substrate surface, a coating composition as claimed in any of claims 1 to 7 to form a film of the coating composition thereon;

     (b) curing the film at an elevated temperature for a sufficient time to solidify the film;

     (c) exposing coated and uncoated substrate surface, to molten solder flux; and

     (d) subsequently peeling off the film from the substrate, whereby the solder does not adhere to that portion of the substrate bearing the film.

9.    A method as claimed in claim 8, in which the substrate is a printed circuit.

10.    A method as claimed in claim 8 or claim 9, in which the coating composition is screen printed onto the substrate.

11.    A method as claimed in any of claims 8 to 10, in which the coating composition is cured at a temperature of from 125°C to 165°C for 2 to 180 minutes.